# EUROPEAN PATENT APPLICATION

(11) **EP 3 896 466 A1**
(43) Date of publication of application: **20.10.2021**
(21) Application number: 19884777.4
(22) Date of filing: 29.08.2019
(51) Int. Cl.: G01R 31/08

(54) **ARRIVAL GROUNDING SAFETY MONITORING SYSTEM FOR RUBBER-WHEELED RAIL VEHICLE**

(30) Priority: 15.11.2018 CN 201811357119
(71) Applicant: CRRC Zhuzhou Locomotive Co., Ltd, Zhuzhou, Hunan 412001 (CN)
(72) Inventor: YAO, Xuebin, Zhuzhou, Hunan 412001 (CN); SHANG, Jiangao, Zhuzhou, Hunan 412001 (CN); TANG, Yongjun, Zhuzhou, Hunan 412001 (CN); FU, Xiang, Zhuzhou, Hunan 412001 (CN); YANG, Xiaodong, Zhuzhou, Hunan 412001 (CN); ZHU, Weijian, Zhuzhou, Hunan 412001 (CN); LV, Yuanbin, Zhuzhou, Hunan 412001 (CN); CHEN, Zhongjie, Zhuzhou, Hunan 412001 (CN); PENG, Ju, Zhuzhou, Hunan 412001 (CN); XIE, Zhaohui, Zhuzhou, Hunan 412001 (CN); YUAN, Yanping, Zhuzhou, Hunan 412001 (CN)
(74) Representative: Ran, Handong
(86) International application number: PCT/CN2019/103157
(87) International publication number: WO 2020/098333

(57) **Abstract**

An arrival grounding safety monitoring system for a rubber-wheeled rail vehicle, comprising a first shoegear (G1) and a second shoegear (G2) disposed on a power supply rail (100), as well as a third shoegear (G3) and a fourth shoegear (G4) disposed on a ground rail (200), wherein the first shoegear (G1) and the second shoegear (G2) are electrically connected by means of a high voltage box (HB) and a traction inverter (VVVF), and both the third shoegear (G3) and the fourth shoegear (G4) are electrically connected to the traction inverter (VVVF); and also comprising a ground monitoring unit (K1) and an arrival monitoring unit (300). The arrival monitoring unit (300) is electrically connected to an enable end of the ground monitoring unit (K1); a first output end of the ground detection unit (K1) is electrically connected to the fourth shoegear (G4); an input end of the ground monitoring unit (K1) is electrically connected to the third shoegear (G3); and a second output end of the ground monitoring unit (K1) is electrically connected to a TCMS system. The present system can monitor whether the arrival grounding of a vehicle is normal, and in addition, control whether the high-voltage power supply circuit of the vehicle is disconnected according to the monitoring result so as to avoid safety accidents caused by the potential difference between the vehicle and the platform.

## Description

### Technical Field

The present invention belongs to the field of rail traffic, and particularly relates to an arrival-ground monitoring system for a rubber-wheeled rail vehicle.

### Background

The running parts of straddle-type monorail vehicles, suspended monorail vehicles, and APM rubber-wheeled vehicles are usually rubber wheels. Rubber is naturally insulated due to its own attributes, which may cause a potential difference between a vehicle and a station area when the vehicle is driven to stop at the station area. If the vehicle has a ground fault at this time, the high level of the vehicle cannot be exported in time, which will cause potential safety hazards.

In order to avoid safety accidents, special ground rails are equipped for rubber-wheeled rail vehicles, so it is crucial whether the vehicles and the ground rails are reliably connected. At present, there is no technical solution designed to monitor whether the rubber-wheeled rail vehicles are grounded reliably.

### Summary

Aiming at the above shortcomings of the prior art, the objective of the present invention is to provide an arrival-ground monitoring system for a rubber-wheeled rail vehicle, which can monitor whether the arriving vehicle is grounded normally, and feed back the ground monitoring result to a train control and management system (TCMS) of the vehicle, and the TCMS controls a high-voltage power supply circuit of the vehicle to stay connected or cut off according to the monitoring result, thereby preventing safety accidents caused by a potential difference between the vehicle and a platform.

In order to solve the above technical problems, the technical solution adopted by the present invention is as follows:
An arrival-ground safety monitoring system for a rubber-wheeled rail vehicle, including a first collector shoe G1 and a second collector shoe G2 that are arranged on a power supply rail, and a third collector shoe G3 and a fourth collector shoe G4 that are arranged on a ground rail, wherein the first collector shoe G1 and the second collector shoe G2 are electrically connected to a traction inverter VVVF through a high voltage box HB, and the third collector shoe G3 and the fourth collector shoe G4 are electrically connected to the traction inverter VVVF; the system further includes a ground monitoring unit K1 and an arrival monitoring unit, the arrival monitoring unit is electrically connected to an enable end of the ground monitoring unit K1, a first output end of the ground monitoring unit is electrically connected to the fourth collector shoe G4, and an input end of the ground monitoring unit K1 is electrically connected to the third collector shoe G3.

With the above structure, the arrival monitoring unit issues an enable signal, and the ground monitoring unit K1 starts monitoring. When the vehicle is grounded normally, the first output end of the ground monitoring unit K1 issues a monitoring signal, and the monitoring signal returns to the input end of the ground monitoring unit K1 via the fourth collector shoe G4 and the third collector shoe G3. If a ground fault occurs, the input end of the ground monitoring unit K1 cannot receive the returned monitoring signal.

Further, a second output end of the ground monitoring unit K1 is electrically connected to a train control and management system (TCMS).

With the above structure, the ground monitoring unit K1 sends ground safety monitoring results to the TCMS.

Further, both the first collector shoe G1 and the second collector shoe G2 are electrically connected to the traction inverter VVVF through a high-speed circuit breaker (HSCB) in the high voltage box HB; and an output end of the TCMS is electrically connected to a control end of the HSCB.

In the event of a ground fault, the TCMS controls the HSCB to trip, thereby cutting off the high-voltage power supply of the vehicle to avoid safety accidents.

As a preferred manner, the arrival monitoring unit includes a speed sensor and a position sensor, output ends of the speed sensor and the position sensor are all electrically connected to the TCMS, an output end of the TCMS is electrically connected to a coil of a first relay K2, and a normally open contact of the first relay K2 is electrically connected to the enable end of the ground monitoring unit K1.

According to the monitoring signals of the speed sensor and the position sensor, the TCMS determines whether the train has stopped in place, thereby controlling the first relay K2 to be powered on or off, therefore activating or deactivating the ground monitoring unit K1.

Further, the system further includes a test switch TEST, and the test switch TEST is connected between a power source and the coil of the first relay K2.

With the above structure, when the vehicle is in a garage, the staff or other maintenance personnel can directly control the first relay K2 to be powered on through the test switch TEST, thereby starting the ground monitoring system.

As a preferred manner, the ground monitoring unit K1 includes a second relay K3, and a normally open contact of the second relay K3 is electrically connected to the TCMS.

When a ground fault occurs, the second relay K3 is powered on, the normally open contact of the second relay K3 is closed, and the TCMS receives a ground fault signal.

### Further, the ground monitoring unit K1 includes an alarm unit ALARM

In the case of a ground fault, the ground monitoring unit K1 controls the alarm unit ALARM to alarm.

Further, the TCMS is electrically connected to a human machine interface (HMI).

With the above structure, the HMI displays ground safety monitoring results and vehicle power supply status.

Further, the third collector shoe G3 includes a first power receiving portion P1 and a second power receiving portion P2 that are insulated from each other, the fourth collector shoe G4 includes a third power receiving portion P3 and a fourth power receiving portion P4 that are insulated from each other, the fourth power receiving portion P4 is electrically connected to the first output end of the ground monitoring unit, and the second power receiving portion P2 is electrically connected to the input end of the ground monitoring unit K1; and both the first power receiving portion P1 and the second power receiving portion P2 are both electrically connected to the traction inverter VVVF.

The third collector shoe G3 and the fourth collector shoe G4 on the ground rail are both composed of two portions that are insulated and non-conductive from each other, wherein one portion is connected to the vehicle to realize vehicle power supply and earth return, and the other portion is connected to the ground monitoring unit K1 for ground monitoring, thereby avoiding mutual influence between the two portions due to stray current and the like.

Further, the power supply rail is grounded through a lightning arrester B01 and a ground resistor R in turn to improve the safety of power supply.

Compared with the prior art, the present invention can monitor whether the arriving vehicle is grounded normally, and feed back the ground monitoring result to the TCMS of the vehicle, and the TCMS controls the high-voltage power supply circuit of the vehicle to stay connected or cut off according to the monitoring result, thereby preventing safety accidents caused by a potential difference between the vehicle and a platform.

### Brief Description of the Drawings

Fig. 1 is a structural diagram of a main control circuit of a ground monitoring unit K1.
Fig. 2 is a working principle diagram of the ground monitoring unit K1.
Fig. 3 is a principle diagram of on-off control of high-voltage power supply of a vehicle.

In the figures: 100 - power supply rail, 200 - ground rail, G1 - first collector shoe, G2 - second collector shoe, G3 - third collector shoe, G4 - fourth collector shoe, HB - high voltage box, HSCB - high-speed circuit breaker, VVVF - traction inverter, K1 - ground monitoring unit, K2 - first relay, K3 - second relay, 300 - arrival monitoring unit, 301 - speed sensor, 302 - position sensor, ALARM - alarm Unit, P1 - first power receiving portion, P2 - second power receiving portion, P3 - third power receiving portion, P4 - fourth power receiving portion, B01 - lightning arrester, R - ground resistor, TEST - test switch.

### Detailed Description of the Embodiments

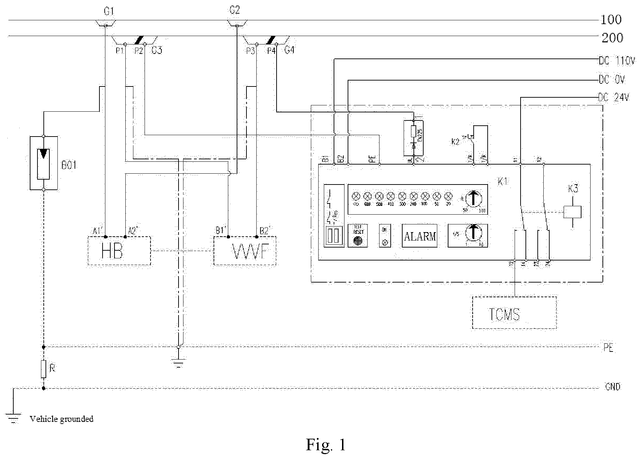

As shown in Figs. 1 to 3, an arrival-ground monitoring system for a rubber-wheeled rail vehicle includes a first collector shoe G1 and a second collector shoe G2 that are arranged on a power supply rail 100, and a third collector shoe G3 and a fourth collector shoe G4 that are arranged on a ground rail 200, wherein the first collector shoe G1 and the second collector shoe G2 are electrically connected to a traction inverter VVVF through a high voltage box HB, and the third collector shoe G3 and the fourth collector shoe G4 are electrically connected to the traction inverter VVVF; the system further includes a ground monitoring unit K1 and an arrival monitoring unit 300, the arrival monitoring unit 300 is electrically connected to an enable end of the ground monitoring unit K1, a first output end of the ground monitoring unit is electrically connected to the fourth collector shoe G4, and an input end of the ground monitoring unit K1 is electrically connected to the third collector shoe G3.

A second output end of the ground monitoring unit K1 is electrically connected to a train control and management system (TCMS).

Both the first collector shoe G1 and the second collector shoe G2 are electrically connected to the traction inverter VVVF through a high-speed circuit breaker (HSCB) in the high voltage box HB; and an output end of the TCMS is electrically connected to a control end of the HSCB.

The arrival monitoring unit 300 includes a speed sensor 301 and a position sensor 302, output ends of the speed sensor 301 and the position sensor 302 are all electrically connected to the TCMS, the output end of the TCMS is electrically connected to a coil of a first relay K2, and a normally open contact of the first relay K2 is electrically connected to the enable end of the ground monitoring unit K1.

The present invention further includes a test switch TEST, and the test switch TEST is connected between a power source and the coil of the first relay K2.

The ground monitoring unit K1 includes a second relay K3, and a normally open contact of the second relay K3 is electrically connected to the TCMS.

### The ground monitoring unit K1 includes an alarm unit ALARM

The TCMS is electrically connected to a human machine interface (HMI).

The third collector shoe G3 includes a first power receiving portion P1 and a second power receiving portion P2 that are insulated from each other, the fourth collector shoe G4 includes a third power receiving portion P3 and a fourth power receiving portion P4 that are insulated from each other, the fourth power receiving portion P4 is electrically connected to the first output end of the ground monitoring unit, and the second power receiving portion P2 is electrically connected to the input end of the ground monitoring unit K1; and both the first power receiving portion P1 and the second power receiving portion P2 are electrically connected to the traction inverter VVVF.

The power supply rail 100 is grounded through a lightning arrester B01 and a ground resistor R in turn.

Based on the above, the control logic relationship of the present invention is:
1) When the vehicle is in a garage, the staff or other maintenance personnel can detect the function of the ground safety monitoring system through the test switch TEST on the operation panel to ensure the normal function of the ground safety monitoring system.
2) When the vehicle is in normal operation, after the TCMS of the vehicle receives a position from the station position sensor 302 and a vehicle arrival stop zero-speed signal from the speed sensor 301, the vehicle is ensured to stop at the station, the first relay K2 works, and the ground monitoring unit K1 works, starts to detect whether the vehicle is grounded and feeds back the detection result to the TCMS; if the vehicle is grounded abnormally or not grounded, that is, a ground fault occurs, the ground monitoring unit K1 controls the alarm unit ALARM to issue an alarm and feeds back the result to the TCMS, the TCMS controls the HSCB to trip, thereby cut off the high-voltage power supply of the vehicle, and the HMI displays ground fault information and vehicle high-voltage power supply cut-off information.

The working principle of the present invention will be described in detail below.

As shown in Fig. 1, the vehicle is connected to the power supply rail 100 through the first collector shoe G1 and the second collector shoe G2 to realize high-voltage power supply of the vehicle. The third collector shoe G3 and the fourth collector shoe G4 are dedicated ground shoes for the vehicle, and are in contact with the ground rail 200. The third collector shoe G3 and the fourth collector shoe G4 are both composed of two separate portions, the first power receiving portion P1 and the third power receiving portion P3 are connected to an HSCB control circuit, and the second power receiving portion P2 and the fourth power receiving portion P4 are connected to a ground monitoring unit K1 control circuit. The two portions of each of the third collector shoe G3 and the fourth collector shoe G4 are insulated by an insulating material, so as to avoid the influence of the locations of the first power receiving portion P1 and the third power receiving portion P3 on the ground monitoring unit K1 or avoid a short circuit in the control system.

The ground monitoring unit K1, the second power receiving portion P2 of the third collector shoe G3, the fourth power receiving portion P4 of the fourth collector shoe G4, and the ground rail 200 constitute a complete detection circuit. A monitoring signal is issued from a point 2 of the ground monitoring unit K1.If the vehicle is grounded normally, the monitoring signal can be fed back to the ground monitoring unit K1 along the point 2 of the ground monitoring unit K1 via the fourth power receiving portion P4 of the fourth collector shoe G4, the ground rail 200, and the second power receiving portion P2 of the third collector shoe G3 by means of a point PE of the ground monitoring unit K1. If the vehicle is grounded abnormally or not grounded, the point PE of the ground monitoring unit K1 cannot receive the monitoring signal. The ground monitoring unit K1 feeds back the detection result to the TCMS of the vehicle, and the TCMS of the vehicle instructs next operation. If the vehicle is grounded abnormally or not grounded, the TCMS controls the HSCB to trip, thereby cut off the high-voltage power supply of the vehicle, and the HMI displays vehicle power cut-off and abnormal ground information.

The HSCB is installed in the high voltage box HB. The traction inverter VVVF converts AC high-voltage power supply to DC voltage for the vehicle control circuit. The TCMS of the vehicle controls the opening and closing of the HSCB to realize the high-voltage power supply of the vehicle.

The vehicle is connected to the high-voltage power supply rail 100 through the first collector shoe G1 and the second collector shoe G2, the first power receiving portion P1 of the third collector shoe G3 and the third power receiving portion P3 of the fourth collector shoe G4 are both connected to the ground rail 200, the high-voltage power supply is connected to the HSCB control circuit through A1' and A2', and the first power receiving portion P1 of the third collector shoe G3 and the third power receiving portion P3 of the fourth collector shoe G4 are connected to the traction inverter VVVF in the HSCB control circuit through B1' and B2', thereby forming a complete main power supply circuit. The connection and disconnection of the high-voltage power supply for the vehicle are controlled by the TCMS and the HSCB control circuit.

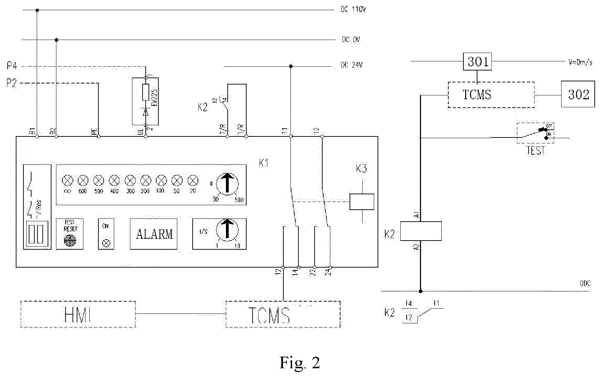

As shown in Fig. 2, the working principle of the ground monitoring unit K1 is as follows:
After the train enters the station, the TCMS of the vehicle determines that the vehicle has stopped in place through the response of the station and the train position sensor 302 and the vehicle zero-speed signal instruction sent by the speed sensor 301, and then controls the first relay K2 to be powered on to work. The switch points 11 and 14 of the first relay K2 are turned on, the ground monitoring unit K1 starts ground detection, and the detection signal is issued from the point 2 and received by the point PE via the monitoring system circuit described in Fig. 1 above. The ground monitoring unit K1 determines whether the vehicle is grounded abnormally or not according to whether the issued signal is received. If the point PE does not receive the detection signal, it indicates that the vehicle is grounded abnormally, and the ground monitoring unit K1 gives an audible and visual alarm through the ALARM

At the same time, the electromagnetic relay in the ground monitoring unit K1 works too, the switching operation turns on the points 11 and 12, the detection result is fed back to the TCMS of the vehicle, and the TCMS controls the HSCB to open or close according to the signal fed back by the ground monitoring unit K1.If the vehicle is grounded normally, the high-voltage power supply of the vehicle will not be cut off. If the vehicle is not grounded, the HSCB will trip, thereby cut off the high-voltage power supply of the vehicle to ensure vehicle safety, and the HMI displays vehicle power supply cut-off and abnormal ground information.

The working principle of a detection bypass control circuit of the ground monitoring system is as follows:
This working circuit is mainly used to detect whether the function of the ground monitoring system is normal. When the vehicle is in the garage or on the test line, the collector shoes are in normal contact with the ground rail 200, the train is activated, the TEST switch button arranged on the operation panel is pressed down, the first relay K2 works, the point 11 of the first relay K2 is connected to the point 14, and the ground monitoring system starts the monitoring operation. In this mode, since the ground connection has been ensured to be normal, if the function of the system is normal, the detection result is normal grounding. If other grounding abnormal conditions occur, it indicates that the function of the system is abnormal and maintenance is required.

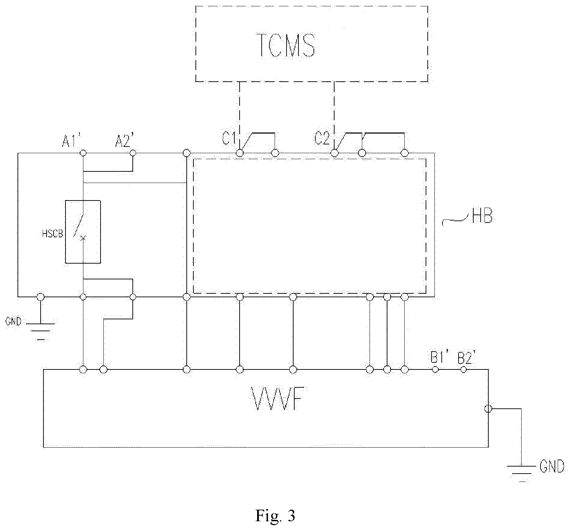

As shown in Fig. 3, a vehicle TCMS control instruction (i.e., an instruction to close or open the HSCB) is input to the HSCB through points C1 and C2 to control the HSCB to open or close, thereby controlling the high-voltage power supply of the vehicle.

The embodiments of the present invention are described above with reference to the drawings, but the present invention is not limited to the specific embodiments. The specific embodiments described above are merely illustrative but not restrictive. Many forms may also be made by those of ordinary skill in the art under the enlightenment of the present invention without departing from the purpose of the present invention and the scope of the claims, and these forms fall into the scope of the present invention.

## Claims

1. An arrival-ground monitoring system for a rubber-wheeled rail vehicle, comprising a first collector shoe G1 and a second collector shoe G2 that are arranged on a power supply rail (100), and a third collector shoe G3 and a fourth collector shoe G4 that are arranged on a ground rail (200), wherein the first collector shoe G1 and the second collector shoe G2 are electrically connected to a traction inverter VVVF through a high voltage box HB, and the third collector shoe G3 and the fourth collector shoe G4 are electrically connected to the traction inverter VVVF, wherein the system further comprises a ground monitoring unit K1 and an arrival monitoring unit (300), the arrival monitoring unit (300) is electrically connected to an enable end of the ground monitoring unit K1, a first output end of the ground monitoring unit is electrically connected to the fourth collector shoe G4, and an input end of the ground monitoring unit K1 is electrically connected to the third collector shoe G3.

2. The arrival-ground monitoring system for the rubber-wheeled rail vehicle according to claim 1, wherein a second output end of the ground monitoring unit K1 is electrically connected to a TCMS.

3. The arrival-ground monitoring system for the rubber-wheeled rail vehicle of claim 2, wherein both the first collector shoe G1 and the second collector shoe G2 are electrically connected to the traction inverter VVVF through a high-speed circuit breaker HSCB in the high voltage box HB; and an output end of the TCMS is electrically connected to a control end of the HSCB.

4. The arrival-ground monitoring system for the rubber-wheeled rail vehicle according to claim 1, wherein the arrival monitoring unit (300) comprises a speed sensor (301) and a position sensor (302), output ends of the speed sensor (301) and the position sensor (302) are all electrically connected to the TCMS, an output end of the TCMS is electrically connected to a coil of a first relay K2, and a normally open contact of the first relay K2 is electrically connected to the enable end of the ground monitoring unit K1.

5. The arrival-ground monitoring system for the rubber-wheeled rail vehicle according to claim 4, further comprising a test switch TEST, and the test switch TEST is connected between a power source and the coil of the first relay K2.

6. The arrival-ground monitoring system for the rubber-wheeled rail vehicle according to any one of claims 1 to 5, wherein the ground monitoring unit K1 comprises a second relay K3, and a normally open contact of the second relay K3 is electrically connected to the TCMS.

7. The arrival-ground monitoring system for the rubber-wheeled rail vehicle according to any one of claims 1 to 5, wherein the ground monitoring unit K1 comprises an alarm unit ALARM

8. The arrival-ground monitoring system for the rubber-wheeled rail vehicle according to any one of claims 2 to 5, wherein the TCMS is electrically connected to a HMI.

9. The arrival-ground monitoring system for the rubber-wheeled rail vehicle according to any one of claims 1 to 5, wherein the third collector shoe G3 comprises a first power receiving portion PI and a second power receiving portion P2 that are insulated from each other, the fourth collector shoe G4 comprises a third power receiving portion P3 and a fourth power receiving portion P4 that are insulated from each other, the fourth power receiving portion P4 is electrically connected to the first output end of the ground monitoring unit, and the second power receiving portion P2 is electrically connected to the input end of the ground monitoring unit K1; and both the first power receiving portion P1 and the second power receiving portion P2 are electrically connected to the traction inverter VVVF.

10. The arrival-ground monitoring system for the rubber-wheeled rail vehicle according to any one of claims 1 to 5, wherein the power supply rail (100) is grounded through a lightning arrester B01 and a ground resistor R in turn.
